(19) Europäisches Patentamt
European Patent Office
Office européen des brevets

(11) **EP 2 214 322 B1**

(12) **EUROPEAN PATENT SPECIFICATION**

(45) Date of publication and mention
of the grant of the patent:
**08.04.2015 Bulletin 2015/15**

(51) Int Cl.:
***H03M 13/39*** *(2006.01)*     *H03M 13/29* *(2006.01)*

(21) Application number: **09290070.3**

(22) Date of filing: **30.01.2009**

(54) **Iterative MAP decoding of block codes using sub-trellises**

Iterative MAP Dekodierung von Block-Kodes unter Verwendung von Sub-Trellises

Décodage itératif de codes en blocs utilisant des sub-treillis

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**04.08.2010 Bulletin 2010/31**

(73) Proprietors:
- **ALCATEL LUCENT**
  **92100 Boulogne-Billancourt (FR)**
- **Centre National de la Recherche Scientifique**
  **75794 Paris Cedex 16 (FR)**
- **Supelec**
  **91192 Gif sur Yvette Cédex (FR)**

(72) Inventors:
- **Marin, Cedric**
  **91310 Montihery (FR)**
- **Kieffer, Michel**
  **92340 Bourg-la-Reine (FR)**
- **Duhamel, Pierre**
  **92350 Le Plessis Robinson (FR)**
- **Kumar, Vinod**
  **75005 Paris (FR)**
- **Sayadi, Bessem**
  **92330 Sceaux (FR)**

(74) Representative: **Vandenbroeck, Josiane Anne Marie et al**
**Alcatel- Lucent Bell NV**
**Intellectual Property and Corporate Standards**
**Copernicuslaan 50**
**2018 Antwerpen (BE)**

(56) References cited:
**US-B1- 7 243 288**

- **YE LIU ET AL: "MAP Algorithms for Decoding Linear Block Codes Based on Sectionalized Trellis Diagrams" IEEE TRANSACTIONS ON COMMUNICATIONS, IEEE SERVICE CENTER, PISCATAWAY, NJ, US, vol. 48, no. 4, 1 April 2000 (2000-04-01), pages 577-587, XP011010820 ISSN: 0090-6778**
- **HARI T MOORTHY ET AL: "Good Trellises for IC Implementation of Viterbi Decoders for Linear Block Codes" IEEE TRANSACTIONS ON COMMUNICATIONS, IEEE SERVICE CENTER, PISCATAWAY, NJ, US, vol. 45, no. 1, 1 January 1997 (1997-01-01), XP011008873 ISSN: 0090-6778**
- **DIVSALAR D ET AL: 'Multiple Turbo Codes for Deep Space Communications' TDA PROGRESS REPORT no. REP. 42-121, 15 May 1995, pages 66 - 77, XP002251816**

**Description**

The present invention relates to a method for decoding block codes.

In modern communication systems, linear block codes are widely used to improve the quality of digital transmissions. At the transmitter side, it consists in adding redundancy (parity bits) to the data to be sent. The resulting codeword is thus composed of two separated parts: the data bits and the parity bits. All these bits are then transmitted over a noisy channel. At the receiver side, the redundancy is exploited by a channel decoding technique to correct the corrupted received data bits. The classical decoding solutions are based on a trellis in which the states represent the different combinations of the parity bits and the inputs correspond to the bits of the codeword. In the article "Efficient Maximum Likelihood Decoding of Linear Block Codes using a Trellis" by J. Wolf, IEEE Transactions on Information Theory, vol. 24, pp. 76-80, Jan. 1978, the author adapts the Viterbi algorithm to the decoding of block codes and proposes a method which minimizes the codeword error probability. In the article "Optimal Decoding of Linear Codes for Minimizing Symbol Error Rate", IEEE Transactions on Information Theory, vol. 20, pp. 284-287, Mar. 1974, written by L. Bahl, J. Cocke, F. Jelinek, and J. Raviv the authors present an optimal method which minimizes the symbol error probability . This algorithm is called the BCJR algorithm. However, these two solutions have a complexity exponential in the number of parity bits and the computational complexity may become huge for long block codes.

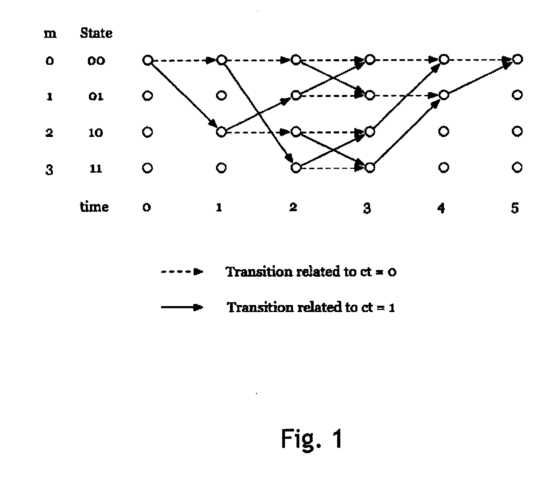

US patent 7243288 presents a reduced-complexity turbo decoding scheme achieving near-optimum performance. The basic idea consists in grouping the parity bits into several partitions assuming statistical independency. Each partition is then successively processed by jointly exploiting the a *posteriori* probability on the bits of codeword, given by the previous decoding stages along with the information associated to the current partition. In this method, each SISO decoder as shown in Fig. 1 of this US patent 7243288 may correspond to a BCJR decoder working on a specific parity partition.

To improve the decoding performance, the inventors of US patent 7243288 also propose to iterate the process. After several iterations, the decoding performance of the suboptimal method tends to the ones obtained with the optimal decoder (i.e., without partitioning the parity bits). Moreover, the complexity of this solution is strongly reduced compared to the optimal solution since it becomes exponential in the number of bits contained in the largest parity subset.

The main disadvantage of this solution is that the decoding process is a serialized one and cannot be parallelized. As shown in Fig. 1 of this US 7243288 patent, one may notice that the second SISO decoder has to wait for the output of the first SISO decoder. As a general principle, the decoding delay increases with the number of partitions in the parity field.

The article "MAP Algorithms for Decoding Linear Block codes based on Sectionalized Trellis Diagrams" by Ye Liu et AI, IEEE Transactions on Communications, IEEE Service Center, Piscataway, NJ, US, vol. 48 Nr 4, 1 April 2000, pages 577-587, XP011010820 ISSN : 0090-6778, describes a bidirectional and parallel MAP decoding.

The article "Good Trelisses for IC Implementation of Viterbi Decoders for Linear Block Codes" by Hari T. Moorthy et AI, IEEE Transactions on Communications, Vol. 45, Nr 1, 1 January 1997, XP011 008873 ISSN : 0090-6778, investigates Trellis structures of Linear Block codes for IC implementation of Viterbi decoders capable of achieving high decoding speed while satifying a constraint on the structural complexity of the Trellis.

It is therefore an object of the present invention to develop a method which achieves near-optimal decoding performance, but which is still computational efficient and fast, so allowing parallel processing.

According to the invention this object is achieved by the method as set out in claim 1.

In this way, by subdividing the parity check matrix into a set of submatrices, a set of subtrellis diagrams will result. This will also mean that each state of the states of the complete trellis diagram will be divided into a set of independent substates. Per substate the different parameters of the coding method can be calculated, and since these substates are each independent of each other, these calculations can be done in parallel. At the end all parameters are combined together to finally come to the desired a posteriori likelihood parameter used in the coding.

By further iterating this process, an even better accuracy can be obtained.

The present invention relates as well to a device and apparatus for implementing the method, as set out in the claim 3.

It is to be noticed that the term 'coupled', used in the claims, should not be interpreted as being limitative to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

It is to be noticed that the term 'comprising', used in the claims, should not be interpreted as being limitative to the means listed thereafter. Thus, the scope of the expression 'a device comprising means A and B' should not be limited to devices consisting only of components A and B. It means that with respect to the present invention, the only relevant components of the device are A and B.

The above and other objects and features of the invention will become more apparent and the invention itself will be best understood by referring to the following description of an embodiment taken in conjunction with the accompanying drawings wherein

Fig. 1 shows an example of a Trellis diagram associated to the block code (5,3) using the parity check matrix

$$\underline{H} = \begin{vmatrix} 1 & 1 & 0 & 1 & 0 \\ 0 & 1 & 1 & 0 & 1 \end{vmatrix}$$

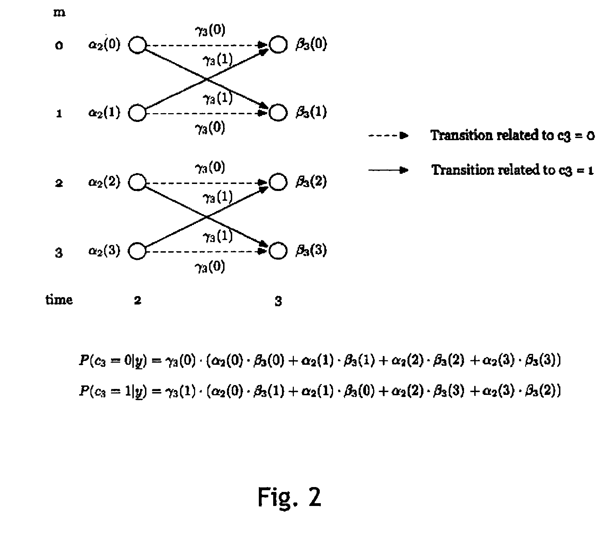

Fig. 2 shows the prior art computation method of the decoding metric at time t=3 for the example of Fig. 1,
Fig. 3 shows the two subtrellis diagrams obtained from partitioning the parity check matrix $\underline{H}$ as shown in Fig. 1, in accordance with an embodiment of the method,
Fig. 4 shows the computation of the decoding metric at time t=3 for this same example, applying the steps according to an embodiment of the method,
Fig. 5 shows a high level embodiment of a decoder according to the invention and
Fig. 6 shows another embodiment of a decoder according to the invention.

The present invention is of interest for decoding of linear block codes using parity check matrices wherein an a posteriori probability parameter has to be computed or calculated for each incoming bit. A known example of such decoding technique is the BCJR algorithm. It will be shown that an embodiment of the method according to the invention can significantly reduce the calculating time and effort for this BCJR algorithm. However also in other algorithms such as the MaxLogMAP algorithm the method can be used.

In order to show the advantages of the method to this BCJR algorithm this known BCJR algorithm will first be described by means of the following example :

Let $\underline{H}$ be the ($n$-$k$,$n$) parity check matrix of a linear ($n$,$k$) block code, corresponding to a codeword of $n$ bits with k bits of data. Assume that $\underline{h}_i$, $i$ = 1,2...$n$, are the column vectors of $\underline{H}$. Let $\underline{c}$ = ($c_1$, $c_2$...$c_n$) be a binary codeword and let $\underline{y}$ = ($y_1$,$y_2$...$y_n$) be the observations of $\underline{c}$ (the information noised by the channel and received by the receiver). The syndrome of the code may be computed recursively over the bits of the codeword as follows

$$\underline{s}_t = \underline{s}_{t-1} \oplus c_t \cdot \underline{h}_t = \sum_{i=1}^{t} c_i \cdot \underline{h}_i \quad (1)$$

with $\underline{s}_0$ = $\underline{0}$, $\underline{s}_n$ = $\underline{0}$, and where $\oplus$ represents the XOR operator. In equation (1), we may notice that the syndrome at time $t$ depends on the syndrome at time $t$-1 and on the current bit of codeword $c_t$. Consequently, a trellis diagram of $2^{n-k}$ =$2^r$ states may be constructed by using equation (1). Each transition is labeled with the appropriate bit of codeword $c_t$. Fig. 1 illustrates the trellis obtained for a block code where

$$\underline{H} = \begin{vmatrix} 1 & 1 & 0 & 1 & 0 \\ 0 & 1 & 1 & 0 & 1 \end{vmatrix}.$$

The BCJR algorithm uses the trellis diagram to minimize the a posteriori probability of bit error. For each input bit $c_t$, $t$ = 1,2...$n$, it consists in determining this a posteriori probability $\Pr(c_t = a \mid \underline{y})$ for the sent value of each bit of the codeword, being either 0 or 1, knowing the (a posteriori) received codeword $\underline{y}$.
This a posteriori probability can be approximated by the value of the joint probability of $c_t$ and the entire vector denoted by $\underline{y}$. This is in its turn equal to the summation of the probabilities over all the states of the trellis at time $t$ as follows

$$\Pr(c_t = a \mid \underline{y}) \propto \Pr(c_t = a, \underline{y}) = \sum_{m=0}^{2^r - 1} \Pr(S_{t-1} = m, S_t = f_t(m,a), \underline{y}) \quad (2)$$

for a =0,1.
In equation (2), $S_t$ represents the numerical value of the vector $\underline{s}_t$. The function $f_t(m,a)$ defines the next state in the trellis when the state at time $t$-1 is $m$ and when the input bit at time $t$ is $a$. After some derivations, we may write equation (2) as

$$\Pr(c_t = a, \underline{y}) = \sum_{m=0}^{2^r-1} \Pr(S_{t-1} = m, \underline{y}_1^{t-1}) \cdot \Pr(a, y_t) \cdot \Pr(\underline{y}_{t+1}^n \mid S_t = f_t(m,a))$$

$$= \sum_{m=0}^{2^r-1} \alpha_{t-1}(m) \cdot \gamma_t(a) \cdot \beta_t(f_t(m,a)) \qquad (3)$$

where:

$$\alpha_{t-1}(m) \quad = \quad \Pr(S_{t-1} = m, \underline{y}_1^{t-1})$$

$$\gamma_t(a) \quad = \quad \Pr(a) \cdot \Pr(y_t \mid a)$$

$$\beta_t(f_t(m,a)) \quad = \quad \Pr(\underline{y}_{t+1}^n \mid S_t = f_t(m,a))$$

In equation (3), $\underline{y}_1^{t-1} = (y_1 \ldots y_{t-1})$ and $\underline{y}_{t+1}^n = (y_{t+1} \ldots y_n)$. The term $\alpha_{t-1}(m)$ represents the sum of probabilities associated to all the combinations of $\underline{c}_1^{t-1} = (c_1 \ldots c_{t-1})$ reaching state $m$ at time $t$-1 in the trellis. Additionally, the term $\beta_t(f_t(m,a))$ denotes the sum of probabilities related to all the combinations of $\underline{c}_{t+1}^n = (c_{t+1} \ldots c_n)$ starting in state $S_t = f_t(m,a)$ at time $t$ in the trellis. Finally, the term $\gamma_t(a)$ corresponds to the a posteriori probability of the current bit $c_t = a$. It has been shown in the prior art that $\alpha_t(m)$ and $\beta_t(m)$ may be recursively computed over the time $t = 0,1\ldots n$ for $m = 0,1\ldots 2^r$ - 1.

More precisely, at time $t$=1,2...$n$, the term $\alpha_t(m)$ may be expressed as

$$\alpha_t(m) = \gamma_t(0) \cdot \alpha_{t-1}(f_{t-1}^{-1}(m,0)) + \gamma_t(1) \cdot \alpha_{t-1}(f_{t-1}^{-1}(m,1)) \qquad (4)$$

for $m = 0,1\ldots 2^r$ - 1. In equation (4), the function $f_{t-1}^{-1}(m,a)$ defines the previous state in the trellis when the state at time $t$ is $m$ and when the input bit at time $t$ is $a$. For $t$=0, we have the boundary conditions

$$\alpha_0(m) = \begin{cases} 1 \text{ if } m = 0 \\ 0 \text{ if } m \neq 0 \end{cases} \qquad (5)$$

Similarly, at time $t = n$-1,$n$-2...0, the term $\beta_t(m)$ may be expressed as

$$\beta_t(m) = \gamma_{t+1}(0) \cdot \beta_{t+1}(f_{t+1}(m,0)) + \gamma_{t+1}(1) \cdot \beta_{t+1}(f_{t+1}(m,1)) \qquad (6)$$

for $m = 0,1\ldots 2^r$ - 1 and the appropriate boundary conditions are

$$\beta_n(m) = \begin{cases} 1 \text{ if } m = 0 \\ 0 \text{ if } m \neq 0 \end{cases} \qquad (7)$$

The decoding steps for computing the probability defined in equation (2) for $t$=1,2...$n$ may thus, according to the known prior art BCJR algorithm be performed as follows :

Step 1: For $m = 0,1...2^r - 1$, $\alpha_0(m)$ and $\beta_n(m)$ are initialized by following the boundary conditions defined in equations (5) and (7).

Step 2: As soon as $\underline{y}$ is received, the BCJR decoder evaluates the values of $\gamma_t(a)$ for $t = 1,2...n$ and $a=0,1$. It then constructs the trellis associated to the current parity check matrix and computes the values of $\alpha_t(m)$ and $\beta_t(m)$ by using equations (4) and (6). The obtained values are stored for all $t=0,1...n$ and $m = 0,1...2^r - 1$.

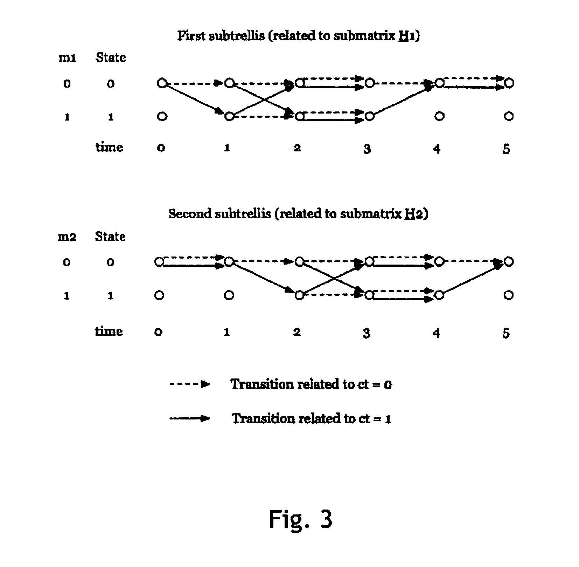

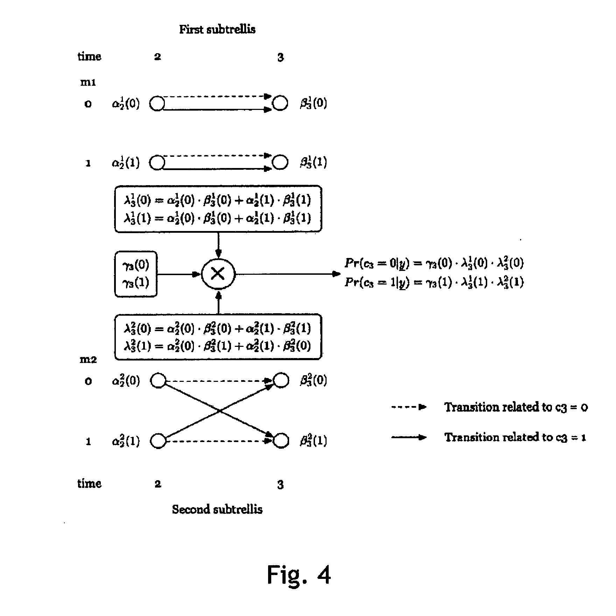

Step 3: The a posteriori probability $P(c_t = a \,|\underline{y})$ defined in equation (2), for $a=0,1$, can finally be evaluated by computing the sum in equation (3) for $t=1,2...n$. The processing details at time $t=3$ are depicted in Fig. 4 for the example studied in Fig. 3.

We will now describe the new decoding approach for the BCJR algorithm. In an embodiment this method is relying on the partitioning of the original parity set. In our example, the parity check matrix $\underline{H}$ is subdivided to generate two parity check submatrix $\underline{H}_1$ and $\underline{H}_2$ as

$$\underline{H}_1 = \begin{bmatrix} 1 & 1 & 0 & 1 & 0 \end{bmatrix} \text{ and } \underline{H}_2 = \begin{bmatrix} 0 & 1 & 1 & 0 & 1 \end{bmatrix}.$$

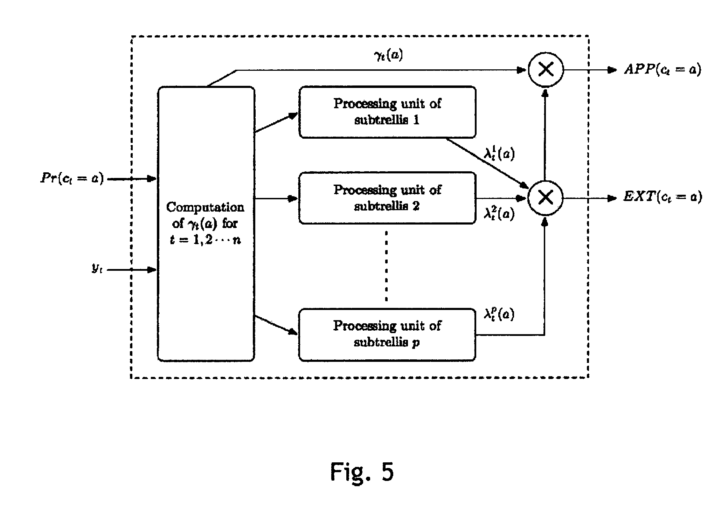

The two resulting subtrellis are illustrated in Fig. 5. In the following, we combine the two subtrellis to provide an approximate evaluation of the probability defined in equation (3).

a- Expression of $\alpha_t$ :

Decomposing any state $m$ into two substates such as $m = (m_1,m_2)$, one may write $\alpha_t(m)$ in equation (3) as

$$\begin{aligned}
\alpha_t(m) = \alpha_t(m_1,m_2) &= \Pr(S_t^1 = m_1, S_t^2 = m_2, \underline{y}_1^t) \\
&= \Pr(S_t^1 = m_1, \underline{y}_1^t) \cdot \Pr(S_t^2 = m_2 \mid S_t^1 = m_1, \underline{y}_1^t)
\end{aligned} \qquad (8)$$

At any time $t = 0,1...n$, $m$ could be divided into two subsets: $m_1 = 0,1...2^{r/2} - 1$ and $m_2 = 0,1...2^{r/2} - 1$.

Assuming that the two substates are independent, equation (8) is approximated by

$$\begin{aligned}
\alpha_t(m_1,m_2) &= \Pr(S_t^1 = m_1, \underline{y}_1^t) \cdot \Pr(S_t^2 = m_2 \mid \underline{y}_1^t) \\
&= \frac{1}{\underline{y}_1^t} \cdot \Pr(S_t^1 = m_1, \underline{y}_1^t) \cdot \Pr(S_t^2 = m_2, \underline{y}_1^t) \\
&\propto \Pr(S_t^1 = m_1, \underline{y}_1^t) \cdot \Pr(S_t^2 = m_2, \underline{y}_1^t) = \alpha_t^1(m_1) \cdot \alpha_t^2(m_2)
\end{aligned} \qquad (9)$$

In equation (9), $\alpha_t^1(m_1)$ and $\alpha_t^2(m_2)$ may be recursively computed over the time $t=1,2...n$ by using the two independent subtrellis of $2^{r/2}$ states and by applying equation (4) to each subtrellis.

b- Expression of $\beta_t$ :

Using the same decomposition, one may write $\beta_t(m)$ in equation (3) as

$$\begin{aligned}
\beta_t(m) = \beta_t(m_1,m_2) &= \Pr(\underline{y}_{t+1}^n \mid S_t^1 = m_1, S_t^2 = m_2) \\
&= \Pr(\underline{y}_{t+1}^n) \cdot \frac{\Pr(S_t^1 = m_1, S_t^2 = m_2 \mid \underline{y}_{t+1}^n)}{\Pr(S_t^1 = m_1, S_t^2 = m_2)}
\end{aligned} \qquad (10)$$

Assuming that the two substates are independent, equation (10) becomes

$$\begin{aligned}
\beta_t(m_1, m_2) &= \Pr(\underline{y}^n_{t+1}) \cdot \frac{\Pr(S^1_t = m_1 \mid \underline{y}^n_{t+1}) \cdot \Pr(S^2_t = m_2 \mid \underline{y}^n_{t+1})}{\Pr(S^n_t = m_1) \cdot \Pr(S^n_t = m_2)} \\
&= \frac{1}{\underline{y}^n_{t+1}} \cdot \Pr(\underline{y}^n_{t+1} \mid S^1_t = m_1) \cdot \Pr(\underline{y}^n_{t+1} \mid S^2_t = m_2) \qquad (11) \\
&\propto \Pr(\underline{y}^n_{t+1} \mid S^1_t = m_1) \cdot \Pr(\underline{y}^n_{t+1} \mid S^2_t = m_2) = \beta^1_t(m_1) \cdot \beta^2_t(m_2)
\end{aligned}$$

In equation (11), $\beta^1_t(m_1)$ and $\beta^2_t(m_2)$ may be recursively computed over the time $t = n\text{-}1, n\text{-}2 \dots 0$ for $m_1 = 0, 1 \dots 2^{r/2} - 1$ and $m_2 = 0, 1 \dots 2^{r/2} - 1$. The recursive evaluation consists in applying equation (6) to the two independent subtrellis.

c- Expression of $\gamma_t$ :

The term $\gamma_t(a)$ does not depend on states and remains unchanged. It may be written as

$$\gamma_t(a) = \Pr(a) \cdot \Pr(y_t \mid a) \qquad (12)$$

and corresponds to the product of the a priori probability and the likelihood associated to the current bit.

d- Combining everything :

Replacing the three terms in equation (3), one gets

$$\begin{aligned}
\Pr(c_t = a \mid \underline{y}) &\propto \sum_{m=0}^{2^r-1} \alpha_{t-1}(m) \cdot \gamma_t(a) \cdot \beta_t(f_t(m,a)) \\
&= \gamma_t(a) \cdot \sum_{m_1, m_2} \alpha_{t-1}(m_1, m_2) \cdot \beta_t(f^1_t(m_1, a), f^2_t(m_2, a)) \\
&= \gamma_t(a) \cdot \left( \sum_{m_1=0}^{2^{r/2}-1} \alpha_{t-1}(m_1) \cdot \beta_t(f^1_t(m_1, a)) \right) \cdot \left( \sum_{m_2=0}^{2^{r/2}-1} \alpha_{t-1}(m_2) \cdot \beta_t(f^2_t(m_2, a)) \right)
\end{aligned}$$

$$(13)$$

In equation (13), the function $f^1_t(m_1, a)$ defines the next state in the first subtrellis when the state at time $t\text{-}1$ is $m_1$ and when the input bit at time $t$ is $a$. Similarly, $f^2_t(m_2, a)$ represents the next state in the second subtrellis when the state at time $t\text{-}1$ is $m_2$ and when the input bit at time $t$ is $a$.

For a sake of clarity, we consider in the following that

$$\lambda^1_t(a) = \sum_{m_1=0}^{2^{r/2}-1} \alpha_{t-1}(m_1) \cdot \beta_t(f^1_t(m_1, a)) \qquad (14)$$

and

$$\lambda^2_t(a) = \sum_{m_2=0}^{2^{r/2}-1} \alpha_{t-1}(m_2) \cdot \beta_t(f^2_t(m_2, a)) \qquad (15)$$

We can now describe the decoding steps of the introduced solution for $t = 1,2...n$.

Step 1: For $m_1 = 0,1...2^{r/2} -1$ and $m_2 = 0,1...2^{r/2} -1$, $\alpha_0^1(m_1)$ and $\beta_n^1(m_1)$ (for the first subtrellis) as well as $\alpha_0^2(m_2)$ and $\beta_n^2(m_2)$ (for the second subtrellis) are initialized by using equations (5) and (7).

Step 2: As soon as $\underline{y}$ is received, the decoder evaluates the values of $\gamma_t(a)$ for $t=1,2...n$ and $a =0,1$. It then constructs the two subtrellis associated to the two parity check submatrix and computes the values of $\alpha_t^1(m_1)$, $\beta_t^1(m_1)$ (relative to the first subtrellis) and $\alpha_t^2(m_2)$, $\beta_t^2(m_2)$ (relative to the second subtrellis) by applying equations (4) and (6). The resulting values are stored for all $m_1$, $m_2$, and $t$.

Step 3: For $t = 1,2...n$, the decoder computes $\lambda_t^1(a)$ and $\lambda_t^2(a)$ by using equations (14) and (15) for a =0,1.

Step 4: The metric defined in equation (13) can finally be evaluated for $t=1,2...n$ and $a=0,1$. The processing details at time $t=3$ are depicted in Fig. 4 for the scenario studied in Fig. 3.

With this method, the two subtrellis can independently be studied by using a parallelized architecture. They are finally combined to provide the global metric ,given in equation (13), for each time $t=1,2...n$.

In the example studied above, we have considered a simple situation in which the original parity set was composed of 2 bits and split into two partitions of 1 bit. Nevertheless, the method may readily be extended to long block codes where a more complex partitioning scheme is required. As an example, the rough processing scheme for $p$ partitions is illustrated in Fig. 5, showing a decoder for performing such a method. In this example, the number of parity bits is superior or equal to $p$ bits. We may notice that the inputs of the system correspond to the a *priori* probabilities $Pr(c_t = a)$ of the codeword bits as well as the associated observations $y_t$, for $t=1,2...n$. A usual starting value for this a priori probability is 0.5. The outputs represent the a posteriori probabilities of the codeword bits $APP(c_t = a) = Pr(c_t = a$

$|\underline{y})$ and an optional output can be the extrinsic information $EXT(c_t = a) = \dfrac{APP(c_t = a)}{\gamma_t(a)}$, for $t = 1,2...n$. For non-iterative embodiments this latter output is optional. However for these embodiments using an iterative process, this kind of information is however desirable.

The a posteriori probability $APP(c_t = a) = Pr(c_t = a|\underline{y})$ for each bit may be further used during to decoding process for generating/determining the best estimates of this received bit (either 0 or 1), based upon its received value and this a posteriori probability . This additional block is not shown in the figures .

To improve the decoding performance from the point of view of accuracy, some embodiments of the method use an iterative process. In these embodiments the calculated value of the *extrinsic* information

$EXT(c_t = a) = \dfrac{APP(c_t = a)}{\gamma_t(a)}$, for $t=1,2...n$ calculated in one step will serve as input for the a priori probability in the next step. To introduce some kind of diversity, useful to improve the convergence for the desired turbo effect the partitions of the matrix are changed through the iterations. As an example, let $\underline{H}$ be a (4,8) parity check matrix such as

$$\underline{H} = \begin{vmatrix} 0 & 1 & 1 & 1 & 1 & 0 & 0 & 0 \\ 1 & 0 & 1 & 1 & 0 & 1 & 0 & 0 \\ 1 & 1 & 0 & 1 & 0 & 0 & 1 & 0 \\ 1 & 1 & 1 & 0 & 0 & 0 & 0 & 1 \end{vmatrix}.$$

In one example the original parity set of 4 bits is going to be split into two partitions of 2 bits. For the first iteration, we can imagine that the first submatrix $\underline{H}_1^1$ is composed of the two first rows of $\underline{H}$ and that the second submatrix $\underline{H}_2^1$ represents the two last rows of $\underline{H}$ such as

$$\underline{H}_1^1 = \begin{vmatrix} 0 & 1 & 1 & 1 & 1 & 0 & 0 & 0 \\ 1 & 0 & 1 & 1 & 0 & 1 & 0 & 0 \end{vmatrix} \text{ and } \underline{H}_2^1 = \begin{vmatrix} 1 & 1 & 0 & 1 & 0 & 0 & 1 & 0 \\ 1 & 1 & 1 & 0 & 0 & 0 & 0 & 1 \end{vmatrix}.$$

Hence, for the first iteration, the first subtrellis is based on $\underline{H}_1^1$ and the second on $\underline{H}_2^1$.

For the second iteration, the first submatrix $\underline{H}_1^2$ may be composed of the first and the third rows of $\underline{H}$, and the second submatrix $\underline{H}_2^2$ of the complementary rows (the second and the fourth rows respectively) such as

$$\underline{H}_1^2 = \begin{vmatrix} 0 & 1 & 1 & 1 & 1 & 0 & 0 & 0 \\ 1 & 1 & 0 & 1 & 0 & 0 & 1 & 0 \end{vmatrix} \text{ and } \underline{H}_2^2 = \begin{vmatrix} 1 & 0 & 1 & 1 & 0 & 1 & 0 & 0 \\ 1 & 1 & 1 & 0 & 0 & 0 & 0 & 1 \end{vmatrix}.$$

For the second iteration, the first subtrellis is thus constructed by using $\underline{H}_1^2$ and the second $\underline{H}_2^2$.

Finally, for the third iteration, the first and the last rows of $\underline{H}$ may be combined in the first submatrix $\underline{H}_1^3$, and the remaining rows in $\underline{H}_2^3$ such as

$$\underline{H}_1^3 = \begin{vmatrix} 0 & 1 & 1 & 1 & 1 & 0 & 0 & 0 \\ 1 & 1 & 1 & 0 & 0 & 0 & 0 & 1 \end{vmatrix} \text{ and } \underline{H}_2^3 = \begin{vmatrix} 1 & 0 & 1 & 1 & 0 & 1 & 0 & 0 \\ 1 & 1 & 0 & 1 & 0 & 0 & 1 & 0 \end{vmatrix}.$$

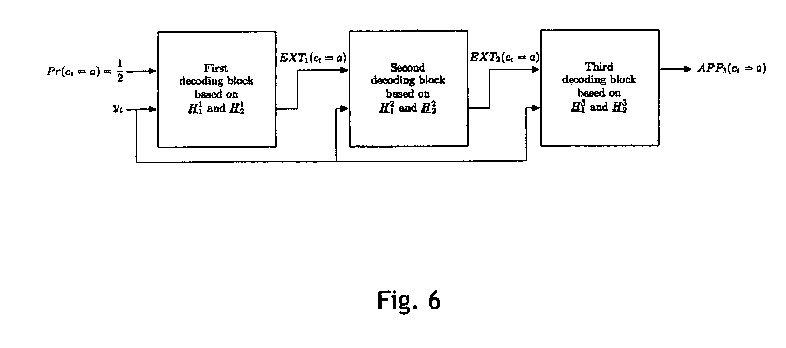

Similarly to the two previous iterations, the first subtrellis for the last iteration is based on $\underline{H}_1^3$ and the second on $\underline{H}_2^3$. The resulting decoding scheme for the three iterations is depicted in Fig. 6. In this figure each decoding block corresponds to a device as depicted in Fig. 5, with the difference that only the first block in the chain uses the a priori incoming information, whereas successive blocks use the extrinsic information as further information. Another difference with the device of Fig. 5 is that only the last block in the chain gives the a posteriori probability.

One may notice that the *extrinsic* information at the output of a decoding block is used as a priori information in the next decoding block. Consequently, the iterative decoding performance relies on the improvement of a *priori* information through iterations. At the last iteration, the improved a posteriori probabilities are given at the output of the last decoding block.

In this example, a simple situation has been considered to illustrate the principle. Indeed, two partitions of 2 bits have been studied, resulting in only three different iterations. In a more general scenario, long block codes are used and the number of iterations can be strongly increased due to a larger diversity in the partitioning design.

The choice of the submatrices partitioning should anyhow be realized in order to increase the diversity. The number of iterations can be fixed or be optimized as well in order to optimize the criterion performance/complexity. For small parity matrices, all the combination can still be used in successive iteration steps .

Compared to the prior art method the subject method, without iterations is already comparable from the point of view of accuracy as the method of US patent 7243288 which uses two iterations. With 3 iterations, such as for example with the embodiment of Fig. 6, accuracy is again increased. For having the same performance the prior art method would need 6 iterations, whereas the decoder of Fig. 6 only needs 3 iterations.

The method as described before for the BCJR algorithm can also be used for other algorithms such as the Max Log MAP algorithm. The Max Log MAP algorithm represents an optimized implementation of BCJR algorithm in order to circumvent problems with the numerical representation of very large or very small numbers and reduce decoding complexity.

While the principles of the invention have been described above in connection with specific apparatus, it is to be clearly understood that this description is made only by way of example and not as a limitation on the scope of the invention, as defined in the appended claims.

**Claims**

**1.** Method for calculating an a posteriori probability for each incoming input bit of a sequence of incoming bits during decoding of a block code, said block code involving states related to a Trellis diagram, said method further including a step of decomposing the parity check matrix associated to the block code into a set of p submatrices, each submatrix being associated with one of p subtrellis diagrams of said Trellis diagram, said method further including the steps of, per subtrellis, and in parallel calculating auxiliary parameters related to the said a posteriori probability, and a step of combining said auxiliary parameters determined in parallel per subtrellis such as to provide the a posteriori probability , wherein an extrinsic information parameter is calculated during the combining step of said auxiliary parameters, and wherein said extrinsic information parameter is used as an input parameter during a succession of iterations of said steps and wherein in each iteration the division of the parity check matrix into a set of submatrices is done in a different way.

2. Method according to claim 1 wherein said a posteriori probability is provided during the last iteration.

3. Apparatus including a sequence of devices for calculating an a posteriori probability for decoding a block code, each device receiving a sequence of incoming bit values and including a computation unit for decomposing the parity check matrix associated to said block code into a set of p submatrices, each submatrix being associated with one of p subtrellis diagrams of said Trellis diagram associated to said block code, each of said devices further including a set of p processing units for per subtrellis, calculating further auxiliary parameters related to the said a posteriori probability, and a combining unit for combining said auxiliary parameters determined in parallel per subtrellis for providing an extrinsic information parameter (EXT) related to the a posteriori probability , wherein the extrinsic information parameter of each device is used as an additional input parameter of the next device, and wherein the last device of the sequence is adapted to provide said a posteriori probability, the apparatus further including control means for controlling each computation block of each device such that for each device the division of the parity check matrix into a set of submatrices is done in a different way.

4. Arrangement for decoding block codes, said arrangement includes an apparatus in accordance with the previous claim 3.

**Patentansprüche**

1. Verfahren zur Berechnung einer A-posteriori-Wahrscheinlichkeit für jedes eingehende Eingangsbit einer Folge von eingehenden Bits während der Decodierung eines Block-Codes, wobei der besagte Block-Code auf ein Trellis-Diagramm bezogene Zustände einbezieht, wobei das besagte Verfahren weiterhin einen Schritt des Zerlegens der mit dem Block-Code assoziierten Paritätsprüfmatrix in einen Satz von p Submatrizen umfasst, wobei jede Submatrix mit einem von p Subtrellis-Diagrammen des besagten Trellis-Diagramms assoziiert ist, wobei das besagte Verfahren weiterhin die Schritte des Berechnens, pro Subtrellis und parallel zueinander, von auf die besagte A-posteriori-Wahrscheinlichkeit bezogenen Hilfsparametern und einen Schritt des Kombinierens der besagten pro Subtrellis und parallel zueinander ermittelten Hilfsparameter umfasst, um die A-posteriori-Wahrscheinlichkeit bereitzustellen, wobei während des Schrittes des Kombinierens der besagten Hilfsparameter ein extrinsischer Informationsparameter berechnet wird, und wobei der besagte extrinsische Informationsparameter während einer Folge von Iterationen der besagten Schritte als ein Eingangsparameter verwendet wird, und wobei bei jeder Iteration die Teilung der Paritätsprüfmatrix in einen Satz von Submatrizen in unterschiedlicher Weise erfolgt.

2. Verfahren nach Anspruch 1, wobei die besagte A-posteriori-Wahrscheinlichkeit während der letzten Iteration bereitgestellt wird.

3. Vorrichtung mit einer Folge von Einrichtungen zur Berechnung einer A-posteriori-Wahrscheinlichkeit zum Decodieren eines Block-Codes, wobei jede Einrichtung eine Folge von eingehenden Bitwerten empfängt, und mit einer Recheneinheit zum Zerlegen der mit dem besagten Block-Code assoziierten Paritätsprüfmatrix in einen Satz von p Submatrizen, wobei jede Submatrix mit einem von p Subtrellis-Diagrammen des besagten mit dem besagten Block-Code assoziierten Trellis-Diagramme assoziiert ist, wobei eine jede der besagten Einrichtungen weiterhin einen Satz von p Verarbeitungseinheiten für die Berechnung, pro Subtrellis, von weiteren auf die besagte A-posteriori-Wahrscheinlichkeit bezogenen Hilfsparametern und eine Kombiniereinheit zum Kombinieren der besagten pro Subtrellis und parallel zueinander ermittelten Hilfsparameter umfasst, um einen auf die A-posteriori-Wahrscheinlichkeit bezogenen extrinsischen Informationsparameter (EXT) bereitzustellen, wobei der extrinsische Informationsparameter einer jeden Einheit als ein zusätzlicher Eingangsparameter der nächsten Einrichtung verwendet wird, und wobei die letzte Einrichtung der Folge dazu ausgelegt ist, die besagte A-posteriori-Wahrscheinlichkeit bereitzustellen, wobei die Vorrichtung weiterhin ein Steuermittel zum Steuern eines jeden Rechenblocks einer jeden Einrichtung umfasst, sodass die Teilung der Paritätsprüfmatrix in einen Satz von Submatrizen für jede Einrichtung in unterschiedlicher Weise erfolgt.

4. Anordnung zum Decodieren von Block-Codes, wobei die besagte Anordnung eine Vorrichtung gemäß dem vorstehenden Anspruch 3 umfasst.

**Revendications**

1. Procédé pour calculer une probabilité a posteriori pour chaque bit d'entrée entrant d'une séquence de bits entrants durant le décodage d'un code de blocs, ledit code de blocs impliquant des états liés à un diagramme en treillis, ledit procédé comprenant en outre une étape de décomposition de la matrice de contrôle de parité associée au code de blocs dans un ensemble de $p$ sous-matrices, chaque sous-matrice étant associée à un parmi $p$ diagrammes en sous-treillis dudit diagramme en treillis, ledit procédé comprenant en outre les étapes de, par sous-treillis et en parallèle, calcul de paramètres auxiliaires liés à ladite probabilité a posteriori, et une étape de combinaison desdits paramètres auxiliaires déterminés en parallèle par sous-treillis de sorte à fournir la probabilité a posteriori, dans lequel un paramètre d'informations extrinsèques est calculé durant l'étape de combinaison desdits paramètres auxiliaires, et dans lequel ledit paramètre d'informations extrinsèques est utilisé comme paramètre d'entrée durant une succession d'itérations desdites étapes et dans lequel dans chaque itération la division de la matrice de contrôle de parité en un ensemble de sous-matrices est réalisée de manière différente.

2. Procédé selon la revendication 1 dans lequel ladite probabilité a posteriori est fournie durant la dernière itération.

3. Appareil comprenant une séquence de dispositifs pour calculer une probabilité a posteriori pour décoder un code de blocs, chaque dispositif recevant une séquence de valeurs binaires entrantes et comprenant une unité de calcul pour décomposer la matrice de contrôle de parité associée audit code de blocs en un ensemble de $p$ sous-matrices, chaque sous-matrice étant associée à un des $p$ diagrammes en sous-treillis dudit diagramme en treillis associé audit code de blocs, chacun desdits dispositifs comprenant en outre un ensemble de $p$ unités de traitement par sous-treillis, et pour calculer d'autres paramètres auxiliaires liés à ladite probabilité a posteriori, et une unité de combinaison pour combiner lesdits paramètres auxiliaires déterminés en parallèle par sous-treillis pour fournir un paramètre d'informations extrinsèques (EXT) lié à la probabilité a posteriori, le paramètre d'informations extrinsèques de chaque dispositif étant utilisé comme paramètre d'entrée supplémentaire du dispositif suivant, et dans lequel le dernier dispositif de la séquence est adapté pour fournir ladite probabilité a posteriori, l'appareil comprenant en outre des moyens de contrôle pour contrôler chaque bloc de calcul de chaque dispositif de sorte que pour chaque dispositif la division de la matrice de contrôle de parité en un ensemble de sous-matrices soit réalisée de manière différente.

4. Dispositif pour décoder des codes de blocs, ledit dispositif comprenant un appareil selon la revendication précédente 3.

Fig. 1

Transition related to $c_3 = 0$

Transition related to $c_3 = 1$

$P(c_3 = 0|\underline{y}) = \gamma_3(0) \cdot (\alpha_2(0) \cdot \beta_3(0) + \alpha_2(1) \cdot \beta_3(1) + \alpha_2(2) \cdot \beta_3(2) + \alpha_2(3) \cdot \beta_3(3))$

$P(c_3 = 1|\underline{y}) = \gamma_3(1) \cdot (\alpha_2(0) \cdot \beta_3(1) + \alpha_2(1) \cdot \beta_3(0) + \alpha_2(2) \cdot \beta_3(3) + \alpha_2(3) \cdot \beta_3(2))$

Fig. 2

First subtrellis (related to submatrix H1)

Second subtrellis (related to submatrix H2)

- - - - ▶  Transition related to ct = 0

——▶  Transition related to ct = 1

Fig. 3

EP 2 214 322 B1

First subtrellis

time        2                3

m1

0    $\alpha_2^1(0)$  ◯ $\dashrightarrow$ ◯  $\beta_3^1(0)$

1    $\alpha_2^1(1)$  ◯ $\dashrightarrow$ ◯  $\beta_3^1(1)$

$$\lambda_3^1(0) = \alpha_2^1(0) \cdot \beta_3^1(0) + \alpha_2^1(1) \cdot \beta_3^1(1)$$
$$\lambda_3^1(1) = \alpha_2^1(0) \cdot \beta_3^1(0) + \alpha_2^1(1) \cdot \beta_3^1(1)$$

$\gamma_3(0)$
$\gamma_3(1)$   $\otimes$

$$Pr(c_3 = 0|\underline{y}) = \gamma_3(0) \cdot \lambda_3^1(0) \cdot \lambda_3^2(0)$$
$$Pr(c_3 = 1|\underline{y}) = \gamma_3(1) \cdot \lambda_3^1(1) \cdot \lambda_3^2(1)$$

$$\lambda_3^2(0) = \alpha_2^2(0) \cdot \beta_3^2(0) + \alpha_2^2(1) \cdot \beta_3^2(1)$$
$$\lambda_3^2(1) = \alpha_2^2(0) \cdot \beta_3^2(1) + \alpha_2^2(1) \cdot \beta_3^2(0)$$

m2

0    $\alpha_2^2(0)$  ◯ ⤫ ◯  $\beta_3^2(0)$

1    $\alpha_2^2(1)$  ◯ ⤫ ◯  $\beta_3^2(1)$

$\dashrightarrow$  Transition related to c3 = 0

$\longrightarrow$  Transition related to c3 = 1

time        2                3

Second subtrellis

Fig. 4

Fig. 5

$Pr(c_t = a) = \dfrac{1}{2}$ → First decoding block based on $H_1^1$ and $H_2^1$ → $EXT_1(c_t = a)$ → Second decoding block based on $H_1^2$ and $H_2^2$ → $EXT_2(c_t = a)$ → Third decoding block based on $H_1^3$ and $H_2^3$ → $APP_3(c_t = a)$

$y_t$ →

Fig. 6

## REFERENCES CITED IN THE DESCRIPTION

**Patent documents cited in the description**

- US 7243288 B

**Non-patent literature cited in the description**

- **J. WOLF.** Efficient Maximum Likelihood Decoding of Linear Block Codes using a Trellis. *IEEE Transactions on Information Theory,* January 1978, vol. 24, 76-80
- **L. BAHL ; J. COCKE ; F. JELINEK ; J. RAVIV.** Optimal Decoding of Linear Codes for Minimizing Symbol Error Rate. *IEEE Transactions on Information Theory,* March 1974, vol. 20, 284-287

- MAP Algorithms for Decoding Linear Block codes based on Sectionalized Trellis Diagrams. **YE LIU et al.** IEEE Transactions on Communications. IEEE Service Center, 01 April 2000, vol. 48, 577-587
- **HARI T. MOORTHY et al.** Good Trelisses for IC Implementation of Viterbi Decoders for Linear Block Codes. *IEEE Transactions on Communications,* 01 January 1997, vol. 45 (1), ISSN 0090-6778